(19) Europäisches Patentamt

European Patent Office

Office européen des brevets

(11) **EP 1 467 490 B1**

(12) **EUROPEAN PATENT SPECIFICATION**

(45) Date of publication and mention
of the grant of the patent:
**02.08.2006   Bulletin 2006/31**

(51) Int Cl.:
***H03M 1/14*** (2006.01)

(21) Application number: **03008345.5**

(22) Date of filing: **10.04.2003**

(54) **Sub-ranging analog-digital converter with increased sampling accuracy and low distortion**

In Unterbereiche aufgeteilter Analog/Digitalwandler mit erhöhter Abtastgenauigkeit und geringer Verzerrung

Convertisseur analogique/numérique à division en sous-gammes avec précision d'échantillonnage augmentée et distorsion diminuée

(84) Designated Contracting States:
**DE GB**

(43) Date of publication of application:
**13.10.2004   Bulletin 2004/42**

(73) Proprietor: **Infineon Technologies AG**
**81669 München (DE)**

(72) Inventor: **Coffey, Anthony**
**Highworth,**
**SN6 7BH Swindon (GB)**

(74) Representative: **Karlsson, Leif Karl Gunnar et al**
**Groth & Co.KB**
**P.O. Box 6107**
**102 32 Stockholm (SE)**

(56) References cited:
**US-A- 3 597 761**          **US-A- 6 011 503**
**US-A- 6 121 912**

• **PATENT ABSTRACTS OF JAPAN vol. 2000, no. 19, 5 June 2001 (2001-06-05) & JP 2001 044837 A (SONY CORP), 16 February 2001 (2001-02-16)**

**Description**

## TECHNICAL FIELD OF THE INVENTION

This invention relates to an analog-digital converter, and in particular to an analog-digital converter with high accuracy, which occupies a relatively small area when implemented in an integrated circuit, and can use relatively low supply voltages.

## BACKGROUND OF THE INVENTION

US-6,011,502 discloses a two-step analog-digital converter, in which an input voltage signal is compared with a series of reference voltages, to provide the most significant bits of a digital output signal. The input voltage signal is then converted to a corresponding current, and an analog current corresponding to the most significant bits of the digital output signal is subtracted from that current. The resulting difference current is compared with a plurality of fine reference currents, and the least significant bits of a digital output signal are calculated on the basis of these comparisons.

Although this document strongly emphasizes the advantages of carrying out this second comparison in current mode, the use of the current mode requires accurate voltage-current conversion.

The patent document US-6,011,503 discloses a half-flash type A/D converter (see Fig. 3) comprising a first plurality of comparators ($CP3_{1-4}$), a first logic block (31), a digital/analog converter (32), a second plurality of comparators ($CP3_{5-8}$), and a second logic block (34).

The digital/analog converter (32) operates in the conventional way.

## SUMMARY OF THE INVENTION

The above- mentioned problem is solved with an analog-digital converter in accordance with Claim 1.

According to an aspect of the present invention, there is provided analog-digital converter, in which an input analog voltage is compared with a plurality of coarse reference voltages, wherein the coarse reference voltages divide the available input voltage range into a plurality of sub-ranges, and include a centre coarse reference voltage; an intermediate analog voltage is generated based on the first comparison; and a difference voltage, representative of a difference between the input analog voltage and the intermediate analog voltage, is compared with a respective plurality of fine reference voltages; in which:

the same intermediate analog voltage is used, for input analog voltages in a first sub-range immediately above the centre coarse reference voltage and a second sub-range immediately below the centre coarse reference voltage; and the fine reference voltages are selected on the basis of the first comparison, suck that the selected fine reference voltages in the case of input analog voltages above the centre coarse reference voltage are inverted relative to the selected fine reference voltages in the case of input analog voltages below the centre coarse reference voltage.

This has the advantage that the analog-digital converter can have higher sampling accuracy, in particular in the most important central part of the available input voltage range. Moreover, for an input voltage which varies symmetrically about the centre of the available input voltage range, the output will be less distorted.

## BRIEF DESCRIPTION OF DRAWINGS

Figure 1 is a block schematic diagram of an analog-digital converter in accordance with the present invention.

Figure 2 is a block schematic diagram of a circuit providing inputs for the circuit shown in Figure 1.

Figure 3 is a more detailed block schematic diagram of a part of the circuit shown in Figure 1.

Figure 4 is a more detailed block schematic diagram of another part of the circuit shown in Figure 1.

Figure 5 illustrates the outputs from the analog-digital converter of Figure 1, for various inputs.

## DETAILED DESCRIPTION OF PREFERRED EMBODIMENTS

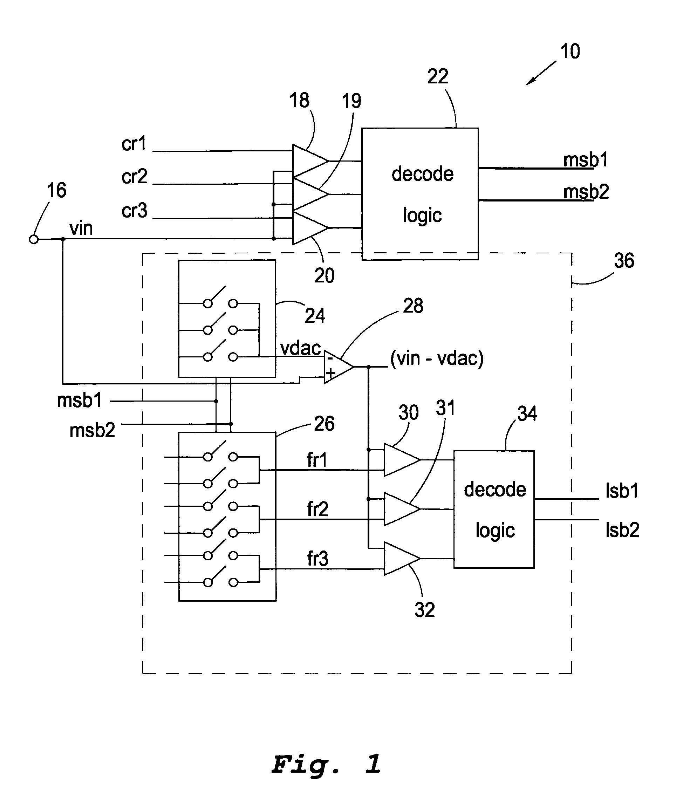

Figure 1 is a block schematic diagram of an analogdigital converter 10. An input differential analog signal vin is received at an input terminal 16, and supplied to the respective first inputs of three differential comparators 18, 19, and 20. The respective second inputs of the comparators 18, 19, 20 receive respective coarse reference values cr1, cr2, and cr3.

The input signal is compared with the coarse reference values cr1, cr2, cr3, and the outputs from the comparators 18, 19, 20 are supplied to a first decode logic block 22. Based on the outputs from the comparators 18, 19, 20, the decode logic block 22 produces a two-bit output made up of bits msb1 and msb2, which are supplied as partial circuit outputs, and are also supplied as control inputs to a digitalanalog converter block 24, and a fine reference selection block 26.

The use of three coarse reference values and three comparators means that the decode logic block provides a two-bit output. It will be appreciated that more coarse reference values and comparators could be used such that the decode logic block provides a longer output, if desired.

Based on its control inputs, msb1, msb2, the digital-analog converter block 24 supplies a differential analog voltage vdac to an inverting input of a subtractor 28. The subtractor 28 also receives the analog circuit input vin from the input terminal 16 as an input on its non-inverting terminal, and supplies an output (vin - vdac), which is equal to the difference between the two inputs.

Based on its control inputs, msb1, msb2, the fine reference selection block 26 outputs three differential fine reference voltages, fr1, fr2 and fr3, as first inputs to respective differential comparators 30, 31, 32. The differential comparators 30, 31, 32 also each receive the output (vin - vdac) from the subtractor 28 as their second input.

The output signals from the comparators 30, 31, 32 are supplied to a second logic decode block 34, which supplies partial circuit outputs lsb1, lsb2 on the basis of these signals.

The use of three fine reference values and three comparators means that the second decode logic block provides a two-bit output. It will be appreciated that more fine reference values and comparators could be used such that the second decode logic block provides a longer output, if desired.

The invention will be described further herein on the basis that the analog-digital converter 10 produces a four-bit output, made up of the partial circuit outputs msb1, msb2 and lsb1, lsb2. However, it will be appreciated that the block 36, shown in dashed lines in Figure 1, could be repeated to allow a longer output word to be formed. Just as the partial output msb1, msb2 is supplied as an input to the block 36 shown in Figure 1, the partial output lsb1, lsb2 could be supplied as an input to a second such block in that case.

The operation of the circuit of Figure 1 will now be described in more detail.

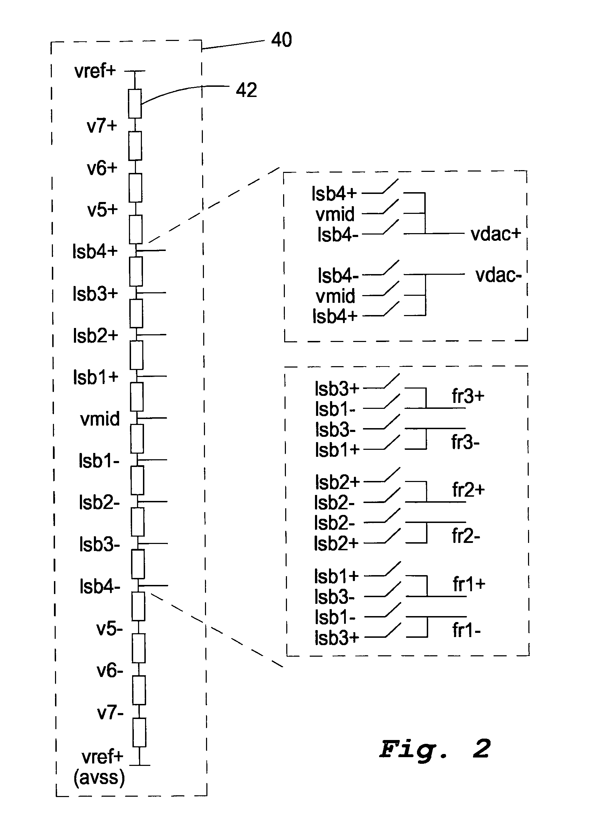

Figure 2 shows a circuit 40 for generating the required reference voltages. The circuit 40 has associated switching circuitry (not shown), which is conventional, and allows the circuitry 40 to generate the coarse reference voltages cr1, cr2, cr3, the analog output from the block 24, and the fine reference voltages from the block 26, as will be described.

The circuit 40 contains a ladder of sixteen matched resistors 42, connected between the circuit supply voltage references vref+ and vref- (the latter being referred to herein also as avss), such that the voltage drop across each of these sixteen resistors is equal. The voltage at the midpoint is defined herein as vmid, the voltages at points one, two, three and four resistors nearer the positive supply voltage vref+ are defined respectively as lsb1+, lsb2+, lsb3+ and lsb4+, and the voltages at points one, two, three and four resistors nearer the negative supply voltage avss are defined respectively as lsb1-, lsb2-, lsb3- and lsb4-.

The voltages at points five, six and seven resistors nearer the positive supply voltage vref+ are defined respectively as v5+, v6+ and v7+, and the voltages at points five, six and seven resistors nearer the negative supply voltage avss are defined respectively as v5-, v6- and v7-.

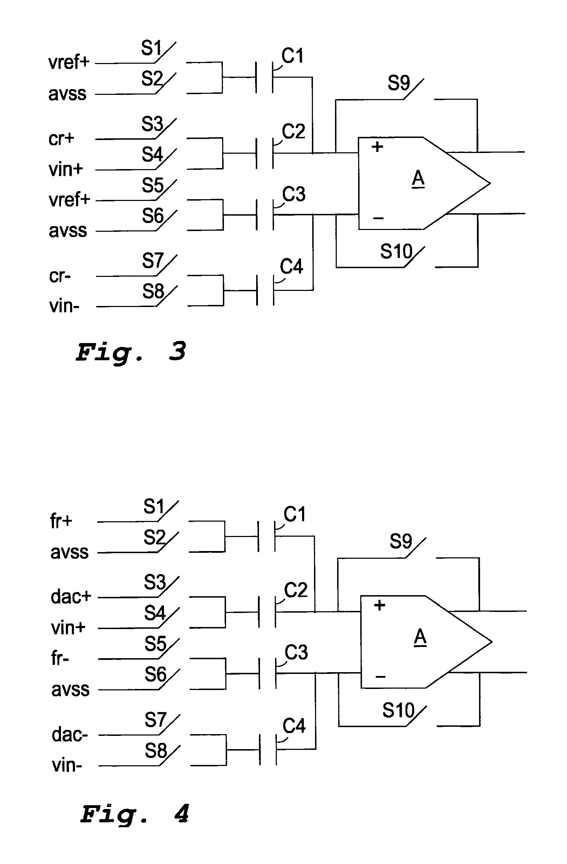

The coarse reference voltages cr1, cr2 and cr3, supplied to the differential comparators 18, 19, 20 respectively, are lsb4+, vmid and lsb4-. Figure 3 is a schematic diagram showing the operation of one of the differential comparators 18, 19, 20, all of which act in the same way. The differential comparator is a conventional device, which receives the circuit positive and negative supply voltages (vref+, avss), the differential circuit input (vin+, vin-) and the respective differential coarse reference voltage (cr+, cr-) on its inputs.

The eight inputs are connected through respective switches S1 - S8 in pairs to four capacitors C1 - C4, and the capacitors C1 and C2 are connected to the "+" input of the amplifier A, while the capacitors C3 and C4 are connected to the "-" input of the amplifier A. If the voltage difference between the "+" and "-" inputs of the amplifier A is positive, the amplifier outputs a logic "0", while, if the voltage difference between the "+" and "-" inputs of the amplifier A is negative, the amplifier outputs a logic "1".

Initially, a first set of switches, S1, S3, S5, S7, S9 and S10, are closed, and a second set, S2, S4, S6, S8, are open. Then, the switches of the second set are closed and the first set are opened. The capacitors C1 - C4 act to present to the amplifier inputs respective voltages which represent the difference between the voltage while the switches of the first set are closed and the voltage while the switches of the second set are closed.

Thus, the comparator evaluates the expression:

$$[(vin+ + avss) - (cr+ + vref+)] - [(avss + vin-) - (cr- - vref+)]$$

This simplifies to:

$$(cr+ - cr-) - (vin+ - vin-)$$

Thus, each of the differential comparators 18, 19, 20 outputs a logic "1" if the differential input analog voltage (vin+ - vin-) is higher than the relevant differential coarse reference voltage (cr+ - cr-), and a logic "0" if the differential input analog voltage is lower than the relevant differential coarse reference voltage.

The three output bits from the three comparators are then supplied to the first logic decode block 22, which supplies a corresponding two-bit output signal. The following table shows the values of the three bits output from the comparators 18, 19, 20 respectively, and the resulting two-bit logic decode block output signals, for input voltages (vin) in specific ranges.

| Input voltage vin | Comparator outputs | Logic decode block output |
|---|---|---|
| avss < vin < lsb4- | 000 | 00 |
| lsb4- < vin < vmid | 001 | 01 |
| vmid < vin < lsb4+ | 011 | 10 |
| 1sb4+ < vin < vref+ | 111 | 11 |

As mentioned above, the two-bit logic decode output is supplied as a control input to the digital-analog converter block 24, and the fine reference selection block 26.

The operation of these blocks is also illustrated in Figure 2. Specifically, Figure 2 illustrates how the value of the analog voltage vdac is selected on the basis of this control input, and how the fine reference voltages fr1, fr2, fr3 for the comparators 30, 31, 32 are selected on the basis of this control input. The following table illustrates the selection of the differential analog voltage vdac on the basis of the logic decode block output.

| Logic decode block output | vdac+ | vdac- |
|---|---|---|
| 00 | lsb4- | lsb4+ |
| 01 | vmid | vmid |
| 10 | vmid | vmid |
| 11 | lsb4+ | lsb4- |

Thus, it can be seen that, although the coarse reference voltages effectively divide the available input voltage range into four sub-ranges, the selected analog voltage is the same for the centre two sub-ranges.

The following table illustrates the selection of the three differential fine reference voltages fr1, fr2 and fr3 on the basis of the logic decode block output.

| Logic decode block output | fr1+ | fr1- | fr2+ | fr2- | fr3+ | fr3- |
|---|---|---|---|---|---|---|
| 00 | lsb3- | lsb3+ | lsb2- | lsb2+ | lsb1- | lsb1+ |
| 01 | lsb3- | lsb3+ | lsb2- | lsb2+ | lsb1- | lsb1+ |

(continued)

| Logic decode block output | fr1+ | fr1- | fr2+ | fr2- | fr3+ | fr3- |
|---|---|---|---|---|---|---|
| 10 | lsb1+ | lsb1- | lsb2+ | lsb2- | lsb3+ | lsb3- |
| 11 | lsb1+ | lsb1- | lsb2+ | lsb2- | lsb3+ | lsb3- |

The fine reference voltages fr1, fr2 and fri, defined as set out above, are then supplied to the differential comparators 30, 31 and 32 respectively. Thus, the voltage (vin - vdac) is compared with a series of fine reference values, which are themselves selected on the basis of the result of the comparison with the coarse reference values.

More specifically, although as discussed above the selected analog voltage is the same for the centre two sub-ranges of the available input voltage range, the selected fine reference voltages are inverted, depending on whether the input voltage is within the upper or lower half of the available input voltage range. This has the advantage that the analog-digital converter can have higher sampling accuracy, in particular in the most important central part of the available input voltage range.

Moreover, it has the advantage that, for an input voltage which varies symmetrically about the centre of the available input voltage range, the output will be less distorted.

Figure 4 is a schematic diagram showing the operation of one of the differential comparators 30, 31, 32, all of which act in the same way, and all of which operate in the same way as the comparator shown in Figure 3. Therefore, the description of Figure 3 will not be repeated here. The differential comparator receives the circuit negative supply voltage (avss), the differential circuit input (vin+, vin-), the differential voltage selected by the block 24 (vdac+, vdac-), and the respective differential fine reference voltage (fr+, fr-) on its inputs.

This comparator evaluates the expression:

$$[ \ (vin+ \ + \ avss) \ - \ (dac+ \ + \ fr+) \ ]-$$
$$[(avss \ + \ vin-) \ - \ (dac- \ - \ fr-)]$$

This simplifies to:

$$(vin+ \quad - \ vin-) \ - \ (dac+ \quad - \ dac-) \ - \ (fr+ \quad - \ fr-)$$

Each of these comparators therefore outputs a logic "1" if the difference between the circuit input and the selected analog voltage (vin - vdac) is higher than the relevant fine reference voltage, and a logic "0" if the difference between the circuit input and the selected analog voltage (vin - vdac) is lower than the relevant coarse reference voltage.

The three output bits from the comparators 30, 31, 32 are then supplied to the second logic decode block 34, which supplies a corresponding two-bit output signal. The following table shows the values of the three bits output from the comparators 18, 19, 20, and the resulting two-bit logic decode block output signals, for input voltages (vin - vdac) in specific ranges.

| (vin-vdac) | Comparator outputs | Logic decode block output |
|---|---|---|
| (vin-vdac) > fr3 | 111 | 11 |
| fr3 > (vin-vdac) > fr2 | 110 | 10 |
| fr2 > (vin-vdac) > fr1 | 100 | 01 |
| fr1 > (vin-vdac) | 000 | 00 |

In this single stage analog-digital converter, producing a four-bit digital output, the two-bit output from the first logic decode block 22 forms the two most significant bits of the analog-digital converter output, while the two-bit output from the second logic decode block 34 forms the two least significant bits of the analog-digital converter output.

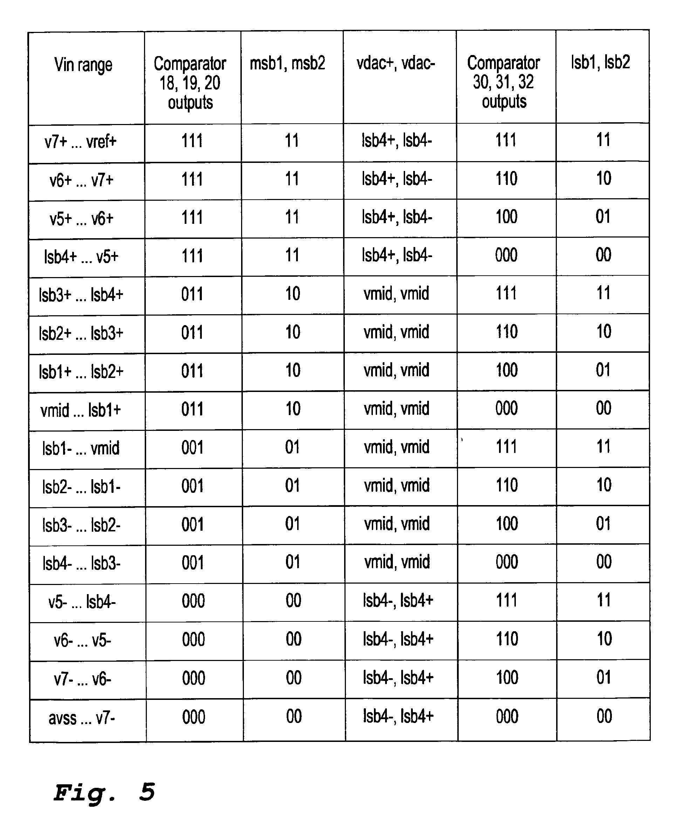

Figure 5 is a table showing the values of certain outputs at points in the circuit, for input voltages vin within particular ranges. Thus, to take one example, for an input voltage vin which is between v5+ and v6+, the three comparators 18, 19, 20 all output logical "1"s, and so the decode logic block 22 produces an output 11. The differential analog voltage vdac+, vdac- is given by vmid, vmid, and this is subtracted from the input voltage vin. In this case, the resulting voltage is higher than the lowest fine reference value fr1, but lower than the other two fine references fr2, fri, and so the comparators 30, 31, 32 produce outputs 100 respectively. These are then decoded in the second decode logic block 34 to produce outputs 01. The outputs from the two decode logic blocks are then combined to form an analog-digital converter output 1101.

There is therefore described an analog-digital converter which produces an accurate output in particular for input voltages in the centre of an available voltage range.

**Claims**

1. An analog-digital converter (10), comprising:

   an input (16) for an input analog voltage (vin) within an available input voltage range;
   a first plurality of comparators (18, 19, 20), for comparing the input analog voltage (vin) with a respective plurality of coarse reference voltages (cr1, cr2, cr3), wherein the coarse reference voltages (cr1, cr2, cr3) divide the available input voltage range into a plurality of sub-ranges, and include a centre coarse reference voltage;
   a first logic block (22), for outputting a first partial digital output (msb1, msb2) on the basis of the comparisons of the input analog voltage (vin) with the coarse reference voltages (cr1, cr2, cr3);
   a digital-analog converter (24), for generating an intermediate analog voltage (vdac) on the basis of the first partial digital output (msb1, msb2);
   a second plurality of comparators (30, 31, 32), for comparing a difference voltage (vin - vdac), representative of a difference between the input analog voltage (vin) and the intermediate analog voltage (vdac), with a respective plurality of fine reference voltages (fr1, fr2, fr3); and
   a second logic block (34), for outputting a second partial digital output (lsb1, lsb2) on the basis of the comparisons of the difference voltage (vin - vdac) with the fine reference voltages (fr1, fr2, fr3);
   **characterized in that** the digital-analog converter (24) is adapted to generate the same intermediate analog voltage (vdac), for input analog voltages in a first sub-range immediately above the centre coarse reference voltage and a second sub-range immediately below the centre coarse reference voltage; and
   wherein the fine reference voltages (fr1, fr2, fr3) are selected on the basis of the first partial digital output (msb1, msb2), such that the selected fine reference voltages (fr1, fr2, fr3) in the case of input analog voltages above the centre coarse reference voltage are inverted relative to the selected fine reference voltages (fr1, fr2, fr3) in the case of input analog voltages below the centre coarse reference voltage.

2. An analog-digital converter (10) as claimed in claim 1, wherein the input analog voltage (vin) and the coarse reference voltages are differential voltages, and the first plurality of comparators (18, 19,20) are differential comparators.

3. An analog-digital converter (10) as claimed in claim 1 or 2, wherein the intermediate analog voltage and the fine reference voltages (fr1, fr2, fr3) are differential voltages, and the second plurality of comparators (30, 31, 32) are differential comparators.

4. An analog-digital converter (10) as claimed in any preceding claim, further comprising a resistor ladder, (42) for generating the coarse reference voltages (cr1 cr2, cr3), the fine reference voltages (fr1, fr2, fr3), and the intermediate analog voltage (vdac).

**Patentansprüche**

1. Analog/Digital-Wandler (10), der umfasst:

   einen Eingang (16) für eine analoge Eingangsspannung (vin) innerhalb eines verfügbaren Eingangsspannungsbereiches;
   eine erste Mehrzahl von Komparatoren (18, 19, 20) zum Vergleichen der analogen Eingangsspannung (vin) mit einer jeweiligen Mehrzahl von Grob-Referenzspannungen (cr1, cr2, cr3), wobei die Grob-Referenzspannungen (cr1, cr2, cr3) den verfügbaren Eingangsspannungsbereich in eine Mehrzahl von Unterbereichen teilen und eine Mitten-Grob-Referenzspannung umfassen;

einen ersten Logikblock (22) zum Ausgeben eines ersten digitalen Teilausgangs (mbs1, mbs2) auf der Basis der Vergleiche der analogen Eingangsspannung (vin) mit den Grob-Referenzspannungen (cr1, cr2, cr3);

einen Digital/Analog-Wandler (24) zum Erzeugen einer analogen Zwischenspannung (vdac) auf der Basis des ersten digitalen Teilausgangs (msb1, msb2);

eine zweite Mehrzahl von Komparatoren (30, 31, 32) zum Vergleichen einer Differenzspannung (vin - vdac), die für eine Differenz zwischen der analogen Eingangsspannung (vin) und der analogen Zwischenspannung (vdac) repräsentativ ist, mit einer jeweiligen Mehrzahl von Fein-Referenzspannungen (fr1, fr2, fr3); und

einen zweiten Logikblock (34) zum Ausgeben eines zweiten digitalen Teilausgangs (lsb1, lsb2) auf der Basis der Vergleiche der Differenzspannung (vin - vdac) mit den Fein-Referenzspannungen (fr1, fr2, fr3);

**dadurch gekennzeichnet, dass**

der Digital/Analog-Wandler (24) ausgelegt ist, dieselbe analoge Zwischenspannung (vdac) für analoge Eingangsspannungen in einem ersten Unterbereich unmittelbar oberhalb der Mitten-Grob-Referenzspannung und einem zweiten Unterbereich unmittelbar unterhalb der Mitten-Grob-Referenzspannung zu erzeugen; und

wobei die Fein-Referenzspannungen (fr1, fr2, fr3) auf der Basis des ersten digitalen Teilausgangs (msb1, msb2) ausgewählt werden, derart, dass die ausgewählten Fein-Referenzspannungen (fr1, fr2, fr3) im Fall von oberhalb der Mitten-Grob-Referenzspannung liegenden analogen Eingangsspannungen relativ zu den im Fall von unterhalb der Mitten-Grob-Referenzspannung liegenden analogen Eingangsspannungen ausgewählten Fein-Referenzspannungen (fr1, fr2, fr3) invertiert werden.

2. Analog/Digital-Wandler (10) gemäß Anspruch 1, wobei die analoge Eingangsspannung (vin) und die Grob-Referenzspannungen differentielle Spannungen sind und die erste Mehrzahl von Komparatoren (18, 19, 20) differentielle Komparatoren sind.

3. Analog/Digital-Wandler (10) gemäß Anspruch 1 oder 2, wobei die analoge Zwischenspannung und die Fein-Referenzspannungen (fr1, fr2, fr3) differentielle Spannungen sind und die zweite Mehrzahl von Komparatoren (30, 31, 32) differentielle Komparatoren sind.

4. Analog/Digital-Wandler (10) gemäß einem der vorhergehenden Ansprüche, der ferner eine Widerstandsleiter (42) umfasst, um die Grob-Referenzspannungen (cr1, cr2, cr3), die Fein-Referenzspannungen (fr1, fr2, fr3) und die analoge Zwischenspannung (vdac) zu erzeugen.

**Revendications**

1. Un convertisseur analogique-numérique (10), comportant : une entrée (16) pour une tension analogique d'entrée (vin) à l'intérieur d'une gamme de tensions d'entrée disponible;

une première pluralité de comparateurs (18, 19, 20), pour comparer la tension analogique d'entrée (vin) avec une pluralité respective de tensions de référence approximatives (cr1, cr2, cr3), dans lesquels les tensions de référence approximatives (cr1, cr2, cr3) divisent la gamme de tensions d'entrée disponible en une pluralité de sous gammes, et comprennent une tension de référence approximative centrale;

un premier bloc logique (22), pour émettre une première sortie numérique partielle (msb1, msb2) sur la base des comparaisons entre la tension analogique d'entrée (vin) et les tensions de référence approximatives (cr1, cr2, cr3);

un convertisseur numérique-analogique (24), pour générer une tension analogique intermédiaire (vdac) sur la base de la première sortie numérique partielle (msb1, msb2);

une deuxième pluralité de comparateurs (30, 31, 32), pour comparer une tension de différence (vin - vdac), représentative d'une différence entre la tension analogique d'entrée (vin) et la tension analogique intermédiaire (vdac), avec une pluralité respective de tensions de référence précises (fr1, fr2, fr3); et

un deuxième bloc logique (34) pour émettre une deuxième sortie numérique partielle (1sb1, 1sb2) sur la base des comparaisons de la tension de différence (vin-vdac) avec les tensions de référence précises (fr1, fr2, fr3);

**caractérisé en ce que** le convertisseur numérique-analogique (24) est adapté pour générer la même tension analogique intermédiaire (vdac), pour des tensions analogiques d'entrée dans une première sous-gamme directement au-dessus de la tension de référence approximative centrale et une deuxième sous-gamme directement au-dessous de la tension de référence approximative centrale; et

dans lequel les tensions de référence précises (fr1, fr2, fr3) sont sélectionnées sur la base de la première sortie numérique partielle (msb1, msb2), de sorte que les tensions de référence précises sélectionnées (fr1, fr2, fr3) dans le cas de tensions analogiques d'entrée au-dessus de la tension de référence approximative centrale sont inversées par rapport aux tensions de référence précises sélectionnées (fr1, fr2, fr3) dans le cas de tensions analogiques de sortie au-dessous de la tension de référence approximative centrale.

2. Un convertisseur analogique-numérique (10) tel que revendiqué dans la revendication 1, dans lequel la tension analogique d'entrée (vin) et les tensions de référence approximatives sont des tensions différentielles, et la première pluralité de comparateurs (18, 19, 20) sont des comparateurs différentiels.

3. Un convertisseur analogique-numérique (10) tel que revendiqué dans la revendication 1 ou 2, dans lequel la tension analogique intermédiaire et les tensions de référence précises (fr1, fr2, fr3) sont des tensions différentielles, et la deuxième pluralité de comparateurs (30, 31, 32) sont des comparateurs différentiels.

4. Un convertisseur analogique-numérique (10) tel que revendiqué dans l'une quelconque des revendications précédentes, comportant en outre une échelle de résistance, (42) pour générer les tensions de référence approximatives (cr1, cr2, cr3), les tensions de référence précises (fr1, fr2, fr3), et la tension analogique intermédiaire (vdac).

*Fig. 1*

Fig. 2

vref+ — S1
avss — S2
C1

cr+ — S3
vin+ — S4
C2

vref+ — S5
avss — S6
C3

cr- — S7
vin- — S8
C4

S9

+

A

−

S10

**Fig. 3**

fr+ — S1
avss — S2
C1

dac+ — S3
vin+ — S4
C2

fr- — S5
avss — S6
C3

dac- — S7
vin- — S8
C4

S9

+

A

−

S10

**Fig. 4**

| Vin range | Comparator 18, 19, 20 outputs | msb1, msb2 | vdac+, vdac- | Comparator 30, 31, 32 outputs | lsb1, lsb2 |
|---|---|---|---|---|---|
| v7+ ... vref+ | 111 | 11 | lsb4+, lsb4- | 111 | 11 |
| v6+ ... v7+ | 111 | 11 | lsb4+, lsb4- | 110 | 10 |
| v5+ ... v6+ | 111 | 11 | lsb4+, lsb4- | 100 | 01 |
| lsb4+ ... v5+ | 111 | 11 | lsb4+, lsb4- | 000 | 00 |
| lsb3+ ... lsb4+ | 011 | 10 | vmid, vmid | 111 | 11 |
| lsb2+ ... lsb3+ | 011 | 10 | vmid, vmid | 110 | 10 |
| lsb1+ ... lsb2+ | 011 | 10 | vmid, vmid | 100 | 01 |
| vmid ... lsb1+ | 011 | 10 | vmid, vmid | 000 | 00 |
| lsb1- ... vmid | 001 | 01 | vmid, vmid | 111 | 11 |
| lsb2- ... lsb1- | 001 | 01 | vmid, vmid | 110 | 10 |
| lsb3- ... lsb2- | 001 | 01 | vmid, vmid | 100 | 01 |
| lsb4- ... lsb3- | 001 | 01 | vmid, vmid | 000 | 00 |
| v5- ... lsb4- | 000 | 00 | lsb4-, lsb4+ | 111 | 11 |
| v6- ... v5- | 000 | 00 | lsb4-, lsb4+ | 110 | 10 |
| v7- ... v6- | 000 | 00 | lsb4-, lsb4+ | 100 | 01 |
| avss ... v7- | 000 | 00 | lsb4-, lsb4+ | 000 | 00 |

## *Fig. 5*